Europäisches Patentamt

**(19)** European Patent Office

Office européen des brevets

**(11)** Publication number : **0 436 848 B1**

**(12)** # EUROPEAN PATENT SPECIFICATION

**(45)** Date of publication of patent specification :
**24.05.95 Bulletin 95/21**

**(51)** Int. Cl.⁶ : **H01L 23/64,** H01L 23/538, H01L 23/66

**(21)** Application number : **90123638.0**

**(22)** Date of filing : **08.12.90**

**(54)** Matched impedance vertical conductors in multilevel metal dielectric laminated wiring.

**(30)** Priority : **10.01.90 US 463068**

**(43)** Date of publication of application :
**17.07.91 Bulletin 91/29**

**(45)** Publication of the grant of the patent :
**24.05.95 Bulletin 95/21**

**(84)** Designated Contracting States :
**DE FR GB**

**(56)** References cited :
**EP-A- 0 035 093**
**EP-A- 0 198 698**
**EP-A- 0 285 064**
**WO-A-84/01470**

**(56)** References cited :
**FR-A- 2 563 656**
**US-A- 4 956 749**
**WO89/08326**
**WO89/08326**

**(73)** Proprietor : **International Business Machines Corporation**
**Old Orchard Road**
**Armonk, N.Y. 10504 (US)**

**(72)** Inventor : **Chance, Dudley Augustus**
**91 Taunton Hill Road**
**Newton, Connecticut 06470 (US)**

**(74)** Representative : **Schäfer, Wolfgang, Dipl.-Ing.**
**IBM Deutschland Informationssysteme GmbH**
**Patentwesen und Urheberrecht**
**D-70548 Stuttgart (DE)**

## Description

The invention relates to impedance matching in the vertical or interplane conductors of multiplane or multilevel wiring structures.

The invention is of particular value in the semiconductor integrated circuit field where the combined progressively more stringent requirements of packaging density and speed of operation are making wiring structures difficult to configure.

In multiplane or multilevel wiring technology, a number of relatively thin substrates are used to support conductor patterns and are assembled into a laminar stack with connections that have come to be known in the art as vias extending through the laminations and interconnecting the wiring on the individual laminations. The technology is usually practiced using patterned conductor deposition techniques that after assembly in a stack the patterns are interconnected through hole patterns aligned between some or all laminations into a unitary wiring package. In the semiconductor technology, the semiconductor chips are usually positioned on the upper surface of the stacked wiring package.

As the overall performance specifications have increased, the wiring structures have been assembled with the high frequency impedance parameters becoming a more prominent consideration.

In the Microelectronics Packaging Handbook edited by R. R. Tummala and E. J. Rymaszewski, Van Nostrand, 1985, pages 18, 138 and 154, there is recognition of the impedance problem.

As the number of laminations still further increased, and the current carrying requirements of power conductors as contrasted with signal conductors became greater, techniques appeared in the art in U.S. Patents 4,649,417 and 4,827,327 that distinguished in the wiring structure between signal and power conductors. A limiting aspect of such an approach to the problem is that a very early decision must be made as to where which type is to be located which reduces flexibility in assembling the wiring configuration.

Heretofore in the art, the impedance problem could be contained. Reference metallization was used to control the impedance of the conductors on the lamination surfaces and the few mils (1 mil = 25.4 μm) of lamination thickness did not produce significant signal delays where the vias passed through the dielectric.

The performance required in the art has now reached the point where delays in signal transmission in the picosecond range, as is encountered in a mismatched impedance via passing through a few plane pairs of dielectric laminations, can no longer be tolerated.

In WO84/01470 a multilayer package including impedance-matched vias in a five-wire configuration is disclosed.

The invention as claimed provides impedance matching capability for the through plane vias in a multiplane laminated wiring structure by arranging vias in a pattern conforming to a standard "characteristic impedance" type configuration of a repeating five-wire configuration with four vias on a grid surrounding the fifth.

For a better understanding of the present invention, together with further objects and advantages, a preferred embodiment of the invention is described in the following with reference to the accompanying drawings, in which:

FIGS. 1 to 3    are a top view and two cross sectional views at different locations illustrating the prior art "plane pair" type laminated wiring structure;

FIG. 4    is an illustration of the critical dimensions of the 5 wire "characteristic impedance" type configuration;

FIGS. 5 to 7    are a top view and two cross sectional views at different locations illustrating the patterned via configuration of a glass ceramic module integrated circuit embodiment of the invention;

FIGS. 8 to 10    are a top view and two cross sectional views at different locations illustrating the location of lines in reference planes to improve zig-zag current path in an integrated circuit glass ceramic module embodiment of the invention;

FIG. 11    is a logarithmic scale graph showing the relationship between the size of chips, the number of via input-output (I/O) terminals and via diameters for a glass ceramic module integrated circuit embodiment of the invention.

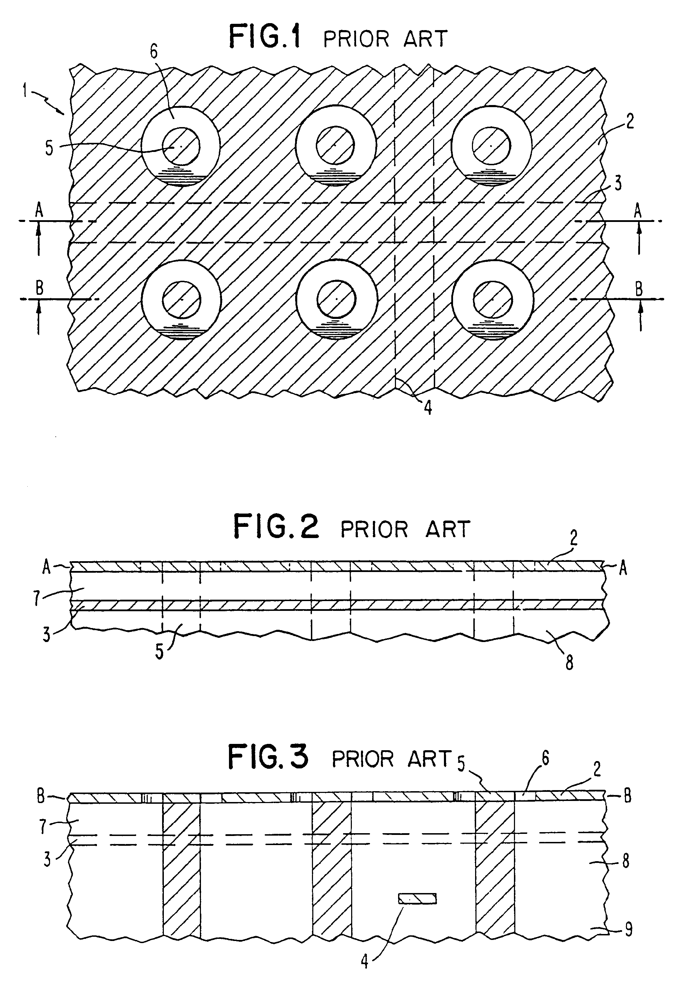

Heretofore in the art, multiplane wiring assemblies or modules have been constructed of layers of wiring patterns separated by relatively thin layers of insulating materials with connections to points in the layers made by conductors called vias running from plane to plane and wherein the signal transmission electrical performance, that is the inductive and capacitive impedance effects were controlled using a type of construction known as the plane pair where a reference conductive plane was positioned between conductor planes. This type of multiplane or multilevel wiring is illustrated in connection with FIGS. 1, 2 and 3 wherein in FIG. 1 there is shown a top view and two cross sectional views of the plane pair type of module construction.

Referring to FIG. 1, in a section 1 of a plane of the assembly, there is an area 2 of conductive material that serves as an electrical reference. In these modules the wiring is distributed on the superimposed planes usually in orthogonal directions. This is illustrated in FIG. 1 by the x-line shown dotted as element 3 and the y-line shown dotted as element 4. Connections to the wiring on the planes is made through a pattern of which six are shown in FIG. 1 of z-direction conductors or vias 5. The reference plane material 2 is separated from each of the vias 5 by a clearance separation shown as element 6.

Referring to FIG. 2, a cross sectional view of the portion of the module of FIG. 1 is shown taken along the lines A-A. In FIG. 2, the electrical reference 2 is shown separated from the x line 3 by a layer 7 of insulating or dielectric material and in turn from other layers below the x line 3 only a portion of a second layer 8 being shown.

Referring next to FIG. 3, another cross sectional view of the portion of a module shown in FIG. 1 is shown taken along the lines B-B through the vias. In FIG. 3 the conductive area 2 is shown with openings 6 surrounding each via 5 and with the y line 4 separated from adjacent planes by the insulating layers 8 and 9. In manufacturing, layers of insulating material are made up with wiring and via segments while in a green or uncured state. The overall laminated structure is subjected to a processing operation that coalesces the insulating layers, conductors and vias into a unitary element or module. This processing operation results in demarcation lines between insulating layers losing definition so that none is shown in FIG. 3.

As the module becomes larger, signal propagation delays, due to impedance effects of inductive and capacitive reactance, become encountered. The inductive and capacitive impedance effects have been controlled in the plane pair type module of FIGS. 1-3 by electrical transmission line type design of the geometry of the lines and their position relative to the electrical reference areas, and the dielectric constant and thickness of the insulating material. Such efforts and terminations in the x-y planes but as the number of laminations increases the part of the interconnections that travel in the z or vertical direction through the vias begins to have a significant effect. The proximity of planes and the density driven reduction of clearance hole sizes cause impedance mismatch and slowing of signal speed.

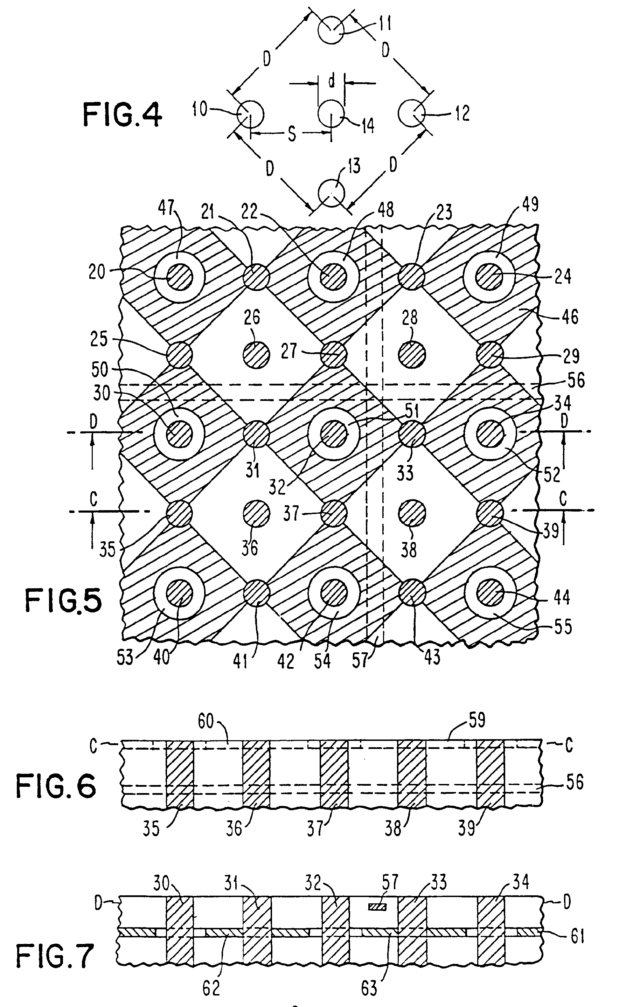

In accordance with the invention, impedance matching capability for the through plane vias is provided by a via arrangement in patterns conforming to a standard characteristic impedance type configuration. The reference plane of the plane-pair type structure is based on the strip-line characteristic impedance known in the art. The invention employs repeating patterns of vias in modules in a characteristic impedance type configuration for multiple conductors, defined by the 5-wire characteristic impedance configuration. In the 5-wire configuration is added the signal carrying via which is placed equidistant from each 4 member combination of the repeating grid. The 5-wire configuration is shown in FIG. 4. In FIG. 4, in a grid of 4 vias 10, 11, 12 and 13 separated from each other by a distance D, there is centrally located a via 14 spaced from each of the vias 10-13 by a distance S. The vias 10-14 all have the same diameter d.

The 5-wire configuration characteristic impedance $Z_0$ has been published in the text Reference Data for Radio Engineers, fourth edition, by International Telephone and Telegraph Corporation, 1963, page 591, wherein for the condition where the via diameter d is less than the separation distance D the characteristic impedance is described by Equation 1.

$$\text{(Equation 1)} \qquad Z_0 = \frac{173}{\sqrt{\varepsilon}} \log_{10} \frac{D}{0.993d}$$

where $\varepsilon$ is the dielectric constant

In accordance with the invention, using glass ceramic as the insulating or dielectric material with a dielectric constant of 5, the characteristic impedance is expressed in accordance with Equation 2.

$$\text{(Equation 2)} \qquad Z_0 = 77.4 \log_{10}(1.516\ S/d)$$

where S = 0.707 D and is the separation distance between the central via and the members of the grid

Further, in accordance with a preferred embodiment of the invention, taking a design characteristic impedance goal of 50 ohms, the via spacing is related to the via diameter by 2.87.

Thus, in FIG. 4, a central via 14 with a diameter of 88,4 $\mu$m (3.48 mils) surrounded by similar vias 11, 12 13 and 14 at a 254 $\mu$m (10 mils) separation distance provides a transmission line with a characteristic impedance of 50 ohms.

Further examples of the 50 ohm, 2.87 spacing to via diameter ratio for the glass ceramic dielectric constant of 5 example are listed in Table 1.

## Table 1

| Via Diameter (d) | | Via Spacing (s) | |
|---|---|---|---|
| μm | (Mils) | μm | (Mils) |
| 99,1 | (3.9) | 287 | (11.3) |
| 88,9 | (3.5) | 254 | (10) |
| 71,1 | (2.8) | 203 | (8) |
| 53,3 | (2.1) | 152 | (6) |

Referring next to FIGS. 5, 6 and 7, there is shown a portion of a multilevel module employing the characteristic impedance configuration via arrangement of the invention. FIG. 5 is a top view and FIGS. 6 and 7 are cross sectional views at different locations showing the 5 wire via configuration. In FIG. 5, the characteristic impedance for each of vias 20-44 in the repeating grid of vias is the design value. The electrical reference conductive area 46 is provided with circular clearance areas 47-55 around vias 20, 22, 24, 30, 32, 34, 40, 42 and 44 and open areas between repeating patterns surrounding vias 26, 28, 36 and 38 resulting in alternate pattern areas being covered. The x and y line buried conductors are labelled 56 and 57, respectively.

Referring next to FIG. 6 which is a cross sectional view of FIG. 5 along the line C-C through vias 35-39. In FIG. 6, the portions of the electrical reference area 46 of FIG. 5 are labelled 59 and 60. The x line is labelled 56. In FIG. 7, there is shown a cross section of FIG. 5 extended in the region below the y line 57 to show the next electrical reference area labelled 61 with the portions of the area 61 at the D-D line being labelled 62 and 63.

The number of signal vias in FIG. 5 is one-fourth the total number and with that pattern areas under a chip can be used for conductors having matched transmission lines in all three x, y and z directions as well as sufficient vias for supplying power to the chip.

It should be noted that the conductive portion of the electrical reference area 46 in FIG. 5 having the pattern of open areas may under certain conditions instead of following a signal line present a zig-zag path. Where this is a problem, short strips of lines may be incorporated in the layout corresponding to the path of the signal line.

The selection of conductor location, electrical reference area shape and conductor and via assignment is made for each plane of the structure and the conductive material applied prior to assembling and coalescing the entire laminate into a unitary module.

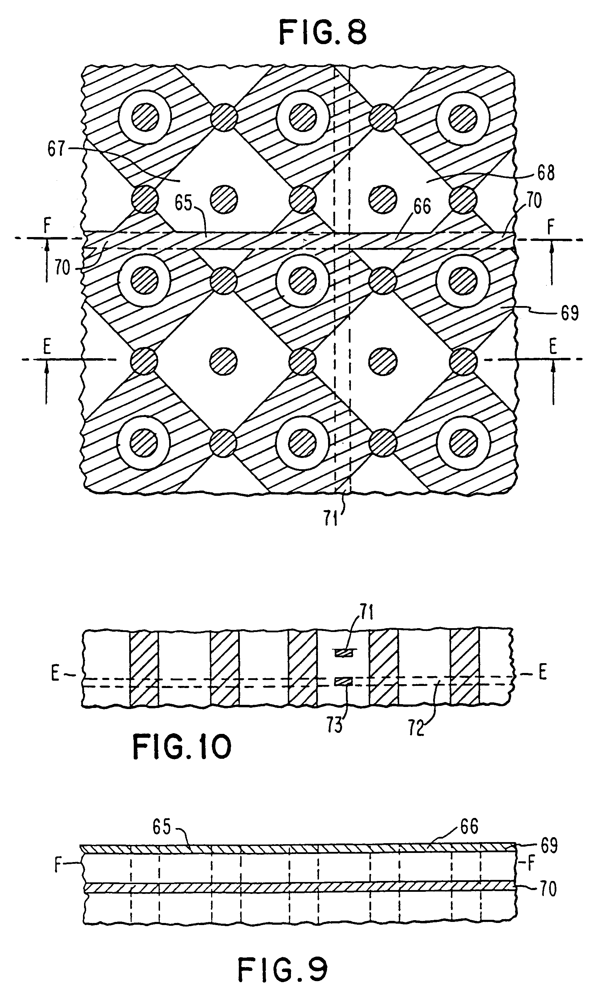

Referring next to FIGS. 8, 9 and 10, the placing of selected short strips in open areas of an electrical reference area is illustrated for a portion of a module with FIG. 8 being a top view and FIGS. 9 and 10 being cross sectional views at different locations. In FIG. 8 short strips 65 and 66 have been programmed into the layout of the conductive material 69 on the plane to cross open areas 67 and 68 adjacent to buried x line 70. The buried y line is labelled 71.

A cross sectional view is shown in FIG. 9 along the line F-F of FIG. 8 showing the x line 70 and the strips 65 and 66 in the electrical reference area 69.

In FIG. 10 a cross sectional view of FIG. 8 is shown illustrating the programmed addition of material in the electrical reference area 72 in the plane under and adjacent to the y line 71.

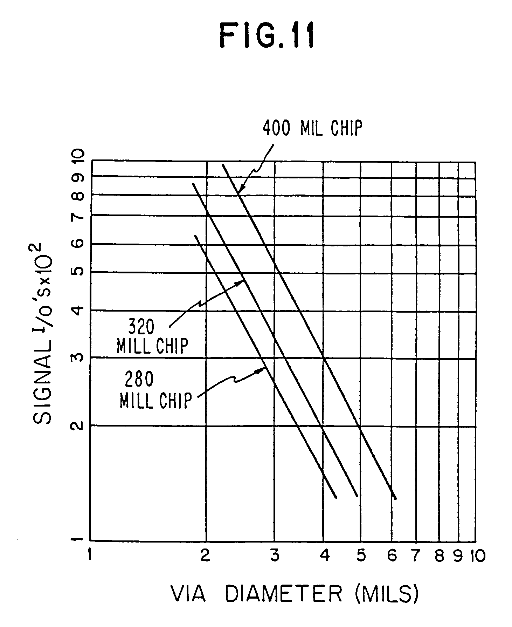

The via impedance matching capability of the invention permits areas under a chip to be used for conductors having matched transmission line impedance characteristics in all three directions as well as providing sufficient vias for supplying power to the chip. Each matched impedance via that passes through a plane pair in a module with insulating material with a dielectric constant of 5, such as glass ceramic, eliminates about a 3 picosecond signal delay. The via diameters have a correlation with the size of the chips and the number of signal input-output (I/O's) when the invention is employed. The graph of FIG. 11 illustrates the relationship in orthogonal logarithmic scales for three progressively larger chip sizes.

What has been described is an impedance matching capability for vias or the z direction of a laminated wiring module that eliminates delays in signal propagation due to inductive or capacitive loadings in travelling through planes at different voltages.

## Claims

1. A multi-level impedance-matched electrical wiring structure for a semiconductor chip wiring package comprising

a plurality of superimposed planes of x and y direction electrical wiring conductors (56,57), whereby the x and y directions are orthogonal,

each plane of said electrical wiring conductors (56,57) being separated by a layer of dielectric material from a parallel plane of broad area reference-potential conductive material (59,61),

a plurality of conductive z-direction signal via members (20,22,24,...) passing through at least one said layer of dielectric material and interconnecting at least one said wiring conductor in one plane with at least one said wiring conductor in at least one other plane,

each said signal via member (20,22,24,...) being located in a repeating grid of conductive z-direction reference-potential via members (21,23,25,...) such that each said signal via member (20,22,24,...) is surrounded by, and equidistant from, four equidistant peripheral reference-potential via members, said signal via members (20,22,24,....) and said reference-potential via members (21,23,25,...) all having the same diameter,

each said signal via member (20,22,24,...) and said surrounding peripheral reference-potential via members further having a member size and member position relationship for defining a specific electrical characteristic impedance and,

said plane of broad area reference-potential conductor material (59,61) comprising first portions enclosed by first ones of said peripheral reference-potential via members that are either free of reference potential conductive material or are free of reference potential conductive material apart from a conductor width strip of conductive material (65,66) adjacent an underlying one of said electrical wiring conductors (56,57) separated by a single dielectric layer, and said plane of broad area reference-potential conductor material (59,61) comprising second portions enclosed by second ones of said peripheral reference-potential via members and comprising areas of said reference-potential conductive material (46) having circular clearance holes (47,48,49,...) free of said reference-potential conductive material (46) around ones of said signal via members enclosed by said second ones of said peripheral reference-potential via members, whereby said first and second portions of said plane of broad area reference-potential conductor material are arranged alternately, thus resulting in a checkerboard-like appearance of said plane of broad area reference-potential conductor material (59,61).

2. The wiring structure of any one of claim 1 wherein said dielectric material is glass ceramic material.

## Patentansprüche

1. Impedanzangepaßte, elektrische Mehrebenen-Verdrahtungsstruktur für eine Halbleiterchip-Verdrahtungspackung umfassend:

eine Mehrzahl überlagerter Ebenen von elektrischen Verdrahtungsleitern (56, 57) in x- und y-Richtung, wobei x- und y-Richtung orthogonal sind,

wobei jede Ebene der elektrischen Verdrahtungsleiter (56, 57) durch eine Schicht aus dielektrischem Material von einer parallelen Ebene aus breitflächigem, leitfähigem Referenzpotential-Material (59, 61) getrennt ist,

eine Mehrzahl von leitfähigen Signal-Durchkontaktelementen (20, 22, 24, ...) in z-Richtung, die durch wenigstens eine der Schichten aus dielektrischem Material hindurchführen und wenigstens einen der Verdrahtungsleiter in einer Ebene mit wenigstens einem Verdrahtungsleiter in wenigstens einer weiteren Ebene verbinden,

wobei jedes Signal-Durchkontaktelement (20, 22, 24, ...) in einem sich wiederholenden Gitter von leitfähigen Referenzpotential-Durchkontaktelementen (21, 23, 25, ...) in z-Richtung so angeordnet ist, daß jedes Signal-Durchkontaktelement (20, 22, 24, ...) von vier äquidistanten, peripheren Referenzpotential-Durchkontaktelementen mit gleichem Abstand umgeben ist, wobei die Signal-Durchkontaktelemente (20, 22, 24, ...) und die Referenzpotential-Durchkontaktelemente (21, 23, 25, ...) alle denselben Durchmesser haben,

wobei jedes Signal-Durchkontaktelement (20, 22, 24, ...) und die umgebenden, peripheren Referenzpotential-Durchkontaktelemente des weiteren bezüglich Elementabmessung und Elementposition in Beziehung zueinander stehen, um eine bestimmte charakteristische elektrische Impedanz zu definieren, und wobei die Ebene des breitflächigen Referenzpotential-Leitermaterials (59, 61) erste Abschnitte beinhaltet, die durch erste der peripheren Referenzpotential-Durchkontaktelemente umgeben sind, die entweder frei von leitfähigem Referenzpotential-Material sind oder mit Ausnahme eines Streifens aus leitfähigem Material (65, 66) mit Leiterbahnbreite frei von leitfähigem Referenzpotential-Material sind, der einem darunterliegenden der elektrischen Verdrahtungsleiter (56, 57) benachbart ist, die durch eine einzelne dielektrische Schicht getrennt sind, und wobei die Ebene des breitflächigen, leitfähigen Referenzpotential-Materials (59, 61) zweite Abschnitte beinhaltet, die von zweiten der peripheren Referenzpotential-Durchkontaktelemente umgeben sind, und Gebiete des leitfähigen Referenzpotential-Materials (46) enthält, die ringförmige Freiraumlöcher (47, 48, 49, ...) frei von leitfähigem Referenzpotential-Material (46), um die jeweiligen Signal-Durchkontaktelemente herum aufweisen, die von den zweiten der peripheren Referenzpotential-Durchkontaktelemente umgeben sind, wobei die ersten und zweiten Abschnitte der Ebene mit dem breitflächigen Referenzpotential-Leitermaterial alternierend angeordnet sind, was in einem schachbrettartigen Aussehen der Ebene mit dem breitflächigen Referenzpotential-Leitermaterial (59, 61) resultiert.

2. Verdrahtungsstruktur nach Anspruch 1, wobei das dielektrische Material Glaskeramikmaterial ist.


**Revendications**

1. Structure de cablage électrique à accord d'impédance multi-niveaux pour un ensemble de cablage de puce semi-conductrice comprenant:
   un ensemble de plans superposés de conducteurs électriques dans des directions x et y (56, 57), les directions x et y étant orthogonales,
   chaque plan desdits conducteurs de cablage électrique (56, 57) étant séparé par une couche de matériau diélectrique d'un plan parallèle de matériau conducteur de potentiel de référence de zone étendue (59, 61),
   un ensemble d'éléments conducteurs de passage de signal de direction z (20, 22, 24) passant à travers au moins une desdites couches de matériau diélectrique et interconnectant au moins un desdits conducteurs de cablage d'un plan avec au moins un desdits conducteurs de cablage d'au moins un autre plan, chacun desdits éléments de passage de signal (20, 22, 24,...) étant situé dans une grille à répétition d'éléments de passage de potentiel de référence de direction z (21, 23, 25, ...) tel que chacun desdits éléments de passage de signal (20, 22, 24,...) soit entouré par, et équidistant de, quatre éléments de passage de potentiel de référence périphériques équidistants, lesdits éléments de passage de signal (20, 22, 24,...) et lesdits éléments de passage de potentiel de référence (21, 23, 25, ...) ayant tous le même diamètre, chacun desdits éléments de passage de signal (20, 22, 24,...) et lesdits élément de passage de potentiel de référence environnants ayant en outre des dimensions et positionnement relatifs permettant de définir un impédance caractéristique électrique spécifique et,
   ledit plan de matériau conducteur de potentiel de référence (59, 61) comprenant des premières parties entourées par des premiers éléments parmi lesdits éléments de passage de potentiel de référence qui sont soit dépourvus de matériau conducteur de potentiel de référence, soit dépourvus de matériau conducteur de potentiel de référence à l'exception d'une bande de matériau conducteur (65, 66) adjacente à un conducteur sous-jacent parmi lesdits conducteurs de cablage électrique (56, 57) séparés par une simple couche diélectrique, et ledit plan de matériau conducteur de potentiel de référence de zone étendue (59, 61) comprenant des secondes parties entourées par des seconds éléments parmi lesdits éléments de passage du potentiel de référence périphériques et comprenant des zones dudit matériau conducteur de potentiel de référence (46) ayant des trous de dégagement circulaire (47, 48, 49, ...) dépourvus dudit matériau conducteur de potentiel de référence (46) entourant un desdits éléments de passage du signal encerclés par lesdits seconds éléments de passage de potentiel de référence périphériques, ce qui fait que lesdites premières et seconde portions de plan de matériau conducteur de potentiel de référence de zone étendue sont disposés de façon alternée d'où il résulte une apparence de panneau de contrôle dudit plan de matériau conducteur de potentiel de référence (59, 61).

2. Structure de cablage selon la revendication 1 dans laquelle ledit matériau diélectrique est de la vitrocéramique.

## FIG.1 PRIOR ART

## FIG.2 PRIOR ART

## FIG.3 PRIOR ART

FIG.4

FIG.5

FIG.6

FIG.7

## FIG.8

67
68
65
66
70
70
69
71

## FIG.10

71
73
72

## FIG.9

65
66
69
70

# FIG.11

400 MIL CHIP

320 MILL CHIP

280 MILL CHIP

SIGNAL I/o's×10²

VIA DIAMETER (MILS)